# EUROPEAN PATENT APPLICATION

(11) **EP 1 981 323 A2**
(43) Date of publication of application: **15.10.2008**
(21) Application number: 07115848.9
(22) Date of filing: 06.09.2007
(51) Int. Cl.: H05K 9/00, H01L 23/552

(54) **Electromagnetic-shielding device**

(30) Priority: 12.04.2007 CN 200720141453 U
(71) Applicant: Horng, Chin-Fu, Taipei Hsien Lu Chou City (TW)
(72) Inventor: Horng, Chin-Fu, Taipei Hsien Lu Chou City (TW)
(74) Representative: Viering, Jentschura & Partner

(57) **Abstract**

An electromagnetic-shielding device (40) disposed in an electronic device (30) prevents that an electric component (42) in the electronic device (30) is interfered by electromagnetic wave. The electromagnetic-shielding device (40) has at least one positioning and leaning wall (50), which is mounted on a laminate member as a part of a housing (46) of the electronic device (30) or a central plate (48) within the electronic device (30). By means of the positioning and leaning wall (50), an electromagnetic-shielding mask (52) is conveniently mounted within the electronic device (30) so as to cover the electronic component (42).

## Description

### BACKGROUND OF THE INVENTION

### 1. Field of the Invention

The present invention generally relates to an electromagnetic-shielding device, more particular to an electromagnetic-shielding device, which employs a laminate member and four positioning and leaning walls in order to let an electromagnetic-shielding mask be easily and precisely cover an electric component in an electronic device.

### 2. Description of the Prior Art

It is possible to avoid interference in electric components such as CPUs, chips, etc. of the PCBs in a mobile phone, PDA, laptop, etc. by outside EMI (electromagnetic interference), so that the components can work properly. On the other hand, the EMI leaking from some powered electric components should also be shielded so as to not cause electromagnetic interference to other outside electronic devices and organisms.

An electromagnetic-shielding mask in the prior art is mounted on a PCB and covers electric components. Such an electromagnetic mask is mounted on the PCB by the ways of welding, fastening, etc. in order to shield EMI.

However, if welding, such as SMT, is adopted, the materials for welding and applying a weld are then limited. Further, the procedures are complicated and the cost of materials is relatively high. On the other hand, the electromagnetic-shielding mask is not easily dismantled during maintenance.

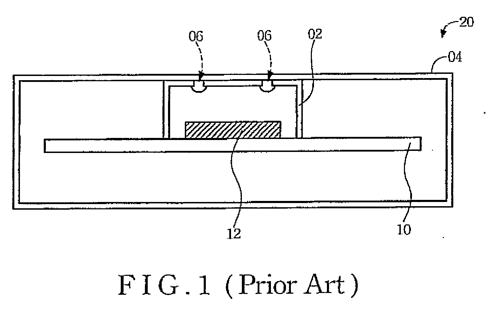

Besides, a known method in the prior art is that of installing an electromagnetic-shielding mask on a central plate of a housing or an electronic device. This is shown in Fig. 1, which illustrates a schematic view of an electromagnetic-shielding mask 2 installed on a housing 4 in the prior art. For the prior art, a plurality of holes 6 is formed on the bottom plate of the electromagnetic-shielding mask 2 in an electronic device 20, and the bottom plate is adhered to the inner surface of the housing 4 through the use of hot melt adhesive and the plurality of holes 6.

However, the electromagnetic-shielding mask 2 is hardly positioned while adhering the electromagnetic-shielding mask 2 to the housing 4. Since some movement is randomly made, the electromagnetic-shielding mask 2 cannot precisely be covered an electric component 12 of a PCB 10 while installing the housing 4; additionally, the installment is hardly finished.

Therefore, the problem of how to provide an advanced structure for the electromagnetic-shielding mask and the housing which is simply and effectively installed is an important issue.

### SUMMARY OF THE INVENTION

The primary objective of the present invention is to provide an electromagnetic-shielding device, which employs a housing or a central plate and at least one positioning and leaning wall in order to let an electromagnetic-shielding mask be easily and precisely covered an electric component in an electronic device. In this way the assembling accuracy is promoted and the error possibility is decreased.

The secondary objective of the present invention is to provide an electromagnetic-shielding device, which structure can be made easily so as to save the cost, including material and labor.

The present invention discloses an electromagnetic-shielding device, which comprises at least one positioning and leaning wall and at least one electromagnetic-shielding mask and is disposed in an electronic device to protect an electric component from interference by electromagnetic wave. A laminate member is disposed within the electronic device and can be a part of the electronic device or a central plate within the electronic device.

The positioning and leaning wall is fixed on the laminate member and elongated toward the electric component. Each side surface of the electromagnetic-shielding mask is traverse leaned on the positioning and leaning wall, and the bottom surface of the electromagnetic-shielding mask is longitudinally leaned on the laminate member, thus the electromagnetic-shielding mask is positioned and covered the electric component.

The electromagnetic-shielding mask is backward and longitudinally adhered to the laminate member by way of glue, hot melt adhesive, twin adhesive, laser welding, laser spot welding, etc.

The electromagnetic-shielding device of the present invention can avoid that the electric component in the electronic device suffers interference by electromagnetic wave. The positioning and leaning wall functions to help that the electromagnetic-shielding mask is accurately mounted on the housing or the central plate in order to promote the precision of assembling the electronic device and decrease the possibility of generating errors. The electromagnetic-shielding device can be constructed very easily due to its simple structure. Further more, mounting the electromagnetic-shielding device lets a conductive sponge be no more existed. Therefore, the material cost for avoiding electromagnetic interference can be highly decreased.

Other and further features, advantages, and benefits of the invention will become apparent in the following description taken in conjunction with the following drawings. It is to be understood that the foregoing general description and following detailed description are exemplary and explanatory but are not to be restrictive of the invention. The accompanying drawings are incorporated in and constitute a part of this application and, together with the description, serve to explain the principles of the invention in general terms. Like numerals refer to like parts throughout the disclosure.

### BRIEF DESCRIPTION OF THE DRAWINGS

The objects, spirits, and advantages of the preferred embodiments of the present invention will be readily understood by the accompanying drawings and detailed descriptions, wherein:
- Fig. 1: illustrates a schematic view of an electromagnetic-shielding mask installing on a housing in prior arts;
- Fig. 2: illustrates a schematic side sectional view of an electromagnetic-shielding device of the present invention;
- Fig. 3: illustrates a schematic top view of a first preferred embodiment of a positioning and leaning wall of the present invention;
- Fig. 4: illustrates a schematic top view of a second preferred embodiment of the positioning and leaning wall of the present invention;
- Fig. 5: a illustrates a schematic sectional view of another preferred embodiment of laminate member of the present invention;
- Fig. 6: illustrates a schematic view of the positioning and leaning wall made by metal of the present invention; and
- Fig. 7: illustrates a schematic view of the positioning and leaning wall made by plastic of the present invention.

### DETAILED DESCRIPTION OF THE INVENTION

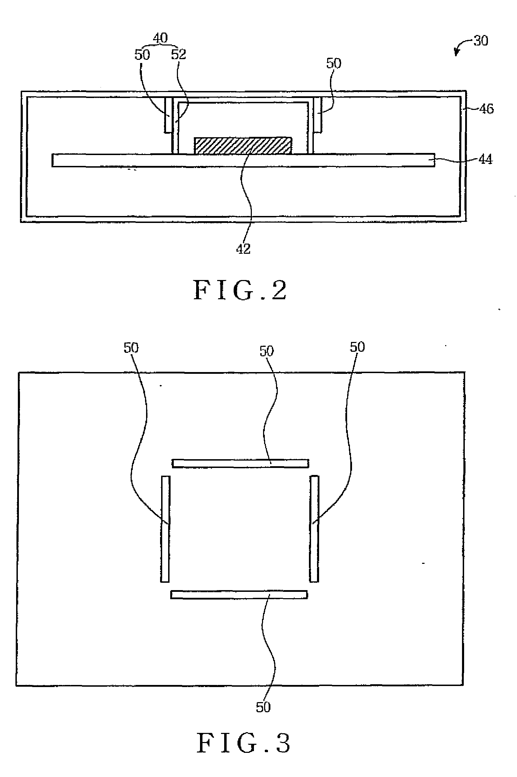

With reference to Fig. 2, which illustrates a schematic side sectional view of an electromagnetic-shielding device 40 of the present invention. The electromagnetic-shielding device 40 is disposed in an electronic device 30 to avoid that an electric component 42 in the electronic device 30 suffers interferance by electromagnetic wave, the electric component 42 is normally disposed in a PCB 44, by which is meant a printed circuit board. A laminate member is defined inside the electronic device 30. As shown in Fig. 2, the laminate member is a part of a housing 46 of the electronic device 30.

The electromagnetic-shielding device 40 including a positioning and leaning wall 50 and an electromagnetic-shielding mask 52. In practice, there may be more than one positioning and leaning wall 50. There are two positioning and leaning walls 50 disposed at both sides respectively in Fig. 2. Each positioning and leaning wall 50 is fixed on the laminate member and elongated toward the electric component 42. Each side surface of the electromagnetic-shielding mask 52 is traverse leaned on each positioning and leaning wall 50, and the bottom surface of the electromagnetic-shielding mask 52 is longitudinally leaned on the laminate member, thus the electromagnetic-shielding mask 52 is positioned and covered the electric component 42.

The electromagnetic-shielding mask is backward and longitudinally adhered to the laminate member by way of glue, hot melt adhesive, twin adhesive, laser welding, laser spot welding, etc.

Fig. 3 illustrates a schematic top view of a first preferred embodiment of the positioning and leaning wall 50 of the present invention. The positioning and leaning wall 50 may not be limited in an aspect of shape. As shown in Fig. 3, each positioning and leaning wall 50 is shaped as a rectangular laminate and corresponds to each side surface of the electromagnetic-shielding mask. Thereby, the four positioning and leaning walls 50 provide an excellent fixing function to the electromagnetic-shielding mask 52.

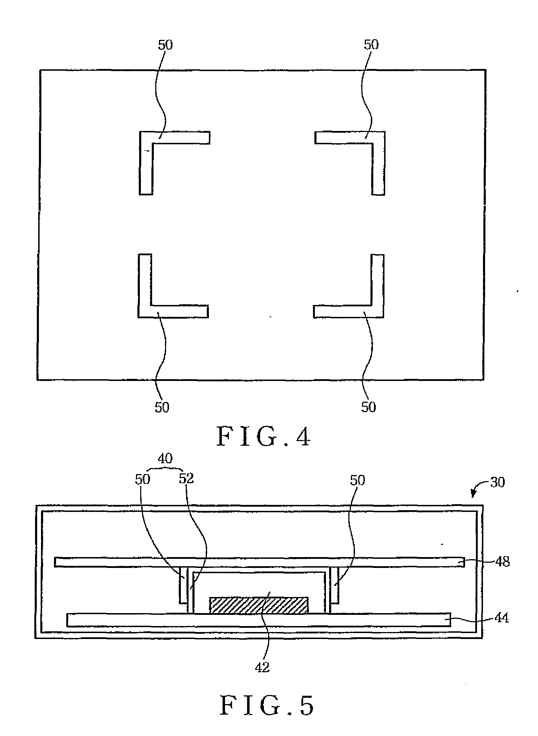

Fig. 4 illustrates a schematic top view of a second preferred embodiment of the positioning and leaning wall 50 of the present invention. As shown in Fig. 4, each positioning and leaning wall 50 is shaped as an L-type laminate and corresponds to each corner of the electromagnetic-shielding mask 52. Thereby, the four positioning and leaning walls 50 provide an excellent fixing function to the electromagnetic-shielding mask 52. In practice, such L-type laminate provides better effect of fixing, and even one L-type laminate can offer 2-dimensional position.

Fig. 5 illustrates a schematic sectional view of another preferred embodiment of the laminate member of the present invention. As shown in Fig. 2, the laminate member is a part of a housing 46 of the electronic device 30; on the other hand, the laminate member can be any member within the electronic device 30. Further referring to Fig. 5, the laminate member is defined as a central plate 48 in the electronic device 30.

The central plate 48 divides the electronic device 30 into two spaces, which are an upper space and a lower space. A PCB 44 is located in the lower space, and the electric component 42 is disposed on the upper surface of the PCB 44. Hence, the electromagnetic-shielding device 40 is disposed on the lower surface of the central plate 48 so as to protect the electric component 42.

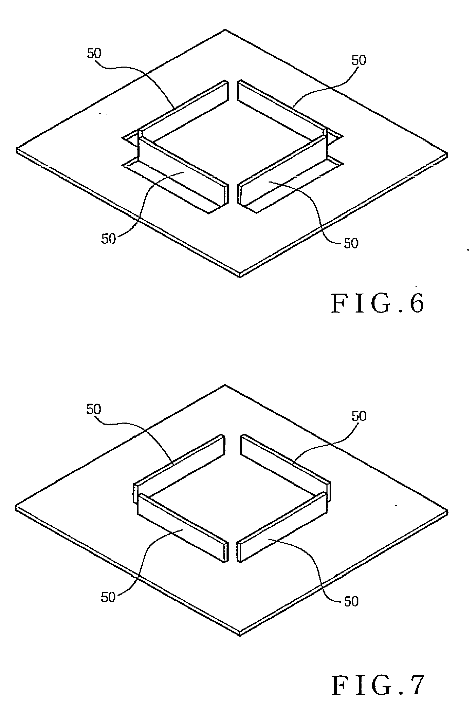

Fig. 6 illustrates a schematic view of the positioning and leaning wall 50 made by metal of the present invention. The material of the positioning and leaning wall 50 is the same as the material of the laminate member, and therefore the manufacturing processes may be simplified. If the laminate member, either the housing 46 or the central plate 48, is made of metal, it can then be punched to form the positioning and leaning wall 50.

Fig. 7 illustrates a schematic view of the positioning and leaning wall 50 made by plastic of the present invention. If the laminate member is made of plastic, that is, the housing 46 or the central plate 48 is made of plastic, thereby the positioning and leaning wall 50 with plastic material can be integrated with the laminate member while in manufacturing. Therefore formation of the positioning and leaning wall 50 allows a cost saving.

As a conclusion, the electromagnetic-shielding device 40 of the present invention can avoid that the electric component 42 in the electronic device 30 is interfered by electromagnetic wave. The positioning and leaning wall 50 functions to help that the electromagnetic-shielding mask 52 is accurately mounted on the housing 46 or the central plate 48 in order to promote the precision of assembling the electronic device 30 and decrease the possibility of generating errors. The electromagnetic-shielding device 40 can be constructed very easily due to its simple structure. Further more, mounting the electromagnetic-shielding device 40 lets a conductive sponge be no more existed. Therefore, the material cost for avoiding electromagnetic interference can be highly decreased.

Although this invention has been disclosed and illustrated with reference to particular embodiments, the principles involved are susceptible for use in numerous other embodiments that will be apparent to persons skilled in the art. This invention is, therefore, to be limited only as indicated by the scope of the appended claims.

## Claims

1. An electromagnetic-shielding device disposed in an electronic device to avoid that an electric component in the electronic device is interfered by electromagnetic wave, a laminate member being defined inside the electronic device, and comprising:
at least one positioning and leaning wall, which is mounted and connected to the laminate member and elongated toward an electric component from the laminate member; and
an electromagnetic-shielding mask, which is traverse leaned on the positioning and leaning wall and longitudinally leaned on the laminate member so as to position and cover the electric component.

2. The electromagnetic-shielding device according to claim 1, wherein the positioning and leaning wall is the shape of rectangular laminate.

3. The electromagnetic-shielding device according to claim 1, wherein the positioning and leaning wall is the shape of L-type laminate.

4. The electromagnetic-shielding device according to claim 1, wherein the electromagnetic-shielding mask is backward and longitudinally adhered to the laminate member by way of glue.

5. The electromagnetic-shielding device according to claim 1, wherein the electromagnetic-shielding mask is longitudinally adhered to the laminate member by way of hot melt adhesive.

6. The electromagnetic-shielding device according to claim 1, wherein the electromagnetic-shielding mask is longitudinally adhered to the laminate member by way of twin adhesive.

7. The electromagnetic-shielding device according to claim 1, wherein the electromagnetic-shielding mask is longitudinally adhered to the laminate member by way of laser welding.

8. The electromagnetic-shielding device according to claim 1, wherein the electromagnetic-shielding mask is longitudinally adhered to the laminate member by way of laser spot welding.

9. The electromagnetic-shielding device according to claim 1, wherein the laminate member is defined as a part of the electronic device.

10. The electromagnetic-shielding device according to claim 1, wherein the laminate member is defined as a central plate within the electronic device.

11. The electromagnetic-shielding device according to claim 1, wherein the positioning and leaning wall is made of plastic.

12. The electromagnetic-shielding device according to claim 1, wherein the laminate member is made of plastic and integrated with the positioning and leaning wall.

13. The electromagnetic-shielding device according to claim 1, wherein the positioning and leaning wall is made of metal.

14. The electromagnetic-shielding device according to claim 13, wherein the laminate member is made of metal, and the positioning and leaning wall is made by way of punching the laminate member.
